# EUROPEAN PATENT SPECIFICATION

(11) **EP 1 786 740 B1**
(45) Date of publication and mention of the grant of the patent: **05.10.2016**
(21) Application number: 05772397.5
(22) Date of filing: 18.07.2005
(51) Int. Cl.: C03C 17/34, C03C 17/245, C03C 17/25

(54) **NANOSTRUCTURED COATINGS AND RELATED METHODS**
NANOSTRUKTURIERTE BESCHICHTUNGEN UND ZUGEHÖRIGE VERFAHREN
REVÊTEMENTS À NANOSTRUCTURE ET PROCÉDÉS ASSOCIÉS

(30) Priority: 22.07.2004 US 897847
(43) Date of publication of application: 23.05.2007
(73) Proprietor: PPG Industries Ohio, Inc., Cleveland, OH 44111 (US)
(72) Inventor: LU, Songwei, Wexford, P 15090 (US); BOYKIN, Cheri, M., Wexford, PA 15090 (US); HARRIS, Caroline, S., Pittsburgh, PA 15206 (US)
(74) Representative: f & e patent
(86) International application number: PCT/US2005/025381
(87) International publication number: WO 2006/020188

(56) References cited:
- WO-A-2004/035496
- US-A1- 2002 150 681
- US-A1- 2003 235 695
- US-A1- 2004 043 260
- US-B1- 6 465 088
- CEMBRERO J ET AL: "Nanocolumnar ZnO films for photovoltaic applications" PREPARATION AND CHARACTERIZATION, ELSEVIER SEQUOIA, NL, vol. 451-452, 22 March 2004 (2004-03-22), pages 198-202, XP004495093 ISSN: 0040-6090

## Description

### Field of the Invention

The present invention relates to coating compositions having photocatalytic properties and related coated articles.

### Background of the Invention

Substrates are used in a variety of applications such as buildings, automobiles, appliances, etc. Oftentimes, the substrates are coated with a functional coating(s) to exhibit the required performance properties. Examples of functional coatings include electroconductive coatings, photocatalytic coatings, thermal management coatings, hydrophilic coatings, etc.

A photocatalytic coating can be applied on a substrate such as glass to keep the surface free of common organic surface contaminants. Known photocatalytic coatings include those made of titania (TiO₂). When the titania coating is exposed to ultraviolet radiation ("UV"), it exhibits photocatalytic properties. Specifically, the coating absorbs UV photons and, in the presence of water or moisture, generates highly reactive hydroxyl radicals that tend to oxidize organic materials on the coated substrate. Ultimately, any organic material on the surface of the coated substrate gets converted to more volatile, lower molecular weight materials that can be washed away or evaporate away.

Typically, the functional coating is deposited directly on the substrate. In many instances when a functional coating is applied the traditional way, the coated substrate exhibits less than optimal durability and undesirable aesthetic properties. Examples of undesirable aesthetic properties include increased reflectance and/or unwanted color. As a result of undesirable aesthetic properties, it is not practical to deposit many functional coatings at their optimal thickness. For example, it is not practical to deposit a photocatalytic coating at the thickness that produces the greatest photocatalytic activity due to unwanted color or high reflectance.

US 2003/0335695 A1 discloses a method and article wherein a substrate is provided with a photocatalytically activated self-cleaning surface by forming a photocatalytically-activated self-cleaning coating on the substrate by spray pyrolysis chemical vapor deposition or magnetron sputter vacuum deposition. The coating has a thickness of at least about 500 Angstroms to limit sodium-ion poisoning to a portion of the coating facing the substrate. Alternatively, a sodium ion diffusion barrier layer is deposited over the substrate prior to the deposition of the photocatalytically-activated self-cleaning coating to prevent sodium ion poisoning of the photocatalytically-activated self-cleaning coating. The substrate includes glass substrates, including glass sheet and continuous float glass ribbon.
WO 2004/035496 A1 discloses a process for producing an article having modified optical, chemical, and/or physical properties. The process comprises (a) fluidizing a starting material; (b) forcing the fluidized starting material toward the article, the article having a certain temperature; and (c) passing the fluidized starting material through a high energy zone, the passing step can occur before the forcing step; after the forcing step but before the fluidizing material comes in contact with the surface of the article; and/or after the forcing step and after the fluidizing material comes in contact with the surface of the article.
US 2004/0043260 A1 relates to a method for cathode spray deposition of a coating with photocatalytic properties comprising titanium oxide at least partly crystallised in anastatic form on a transparent or semi-transparent support substrate, such as glass, vitroceramic, plastic.

The present invention provides a coated substrate that includes an undercoating and a functional coating that is applied over the undercoating. The coated substrate according to the present invention can exhibit improved performance properties such as aesthetic properties, durability, photocatalytic activity, etc.

In a non-limiting embodiment, the present invention is a coated glass substrate as defined in claim 5. The coated glass substrate is formed by a process comprising *inter alia* depositing an undercoating comprising a mixture of silica and alumina over at least a portion of the substrate; fluidizing a precursor for titania nanostructures selected from titanium tetra iso-propoxide, titanium tetra chloride, titanium tetra n-butoxide, titanium tetraethoxide, titanium tetra methoxide, titanyl acetylacetonate, titanium tetrapropoxide and titanium tetra (triethanolaminato); and forcing the fluidized precursor toward the substrate to coat the undercoating with nanostructures.

In another non-limiting embodiment, the present invention is a method of making a coated substrate as defined in claim 1. The method comprises *inter alia*: depositing an undercoating over at least a portion of the substrate; fluidizing a precursor for nanostructures; and forcing the fluidized precursor toward the substrate to coat the undercoating with nanostructures.

### Description Of The Invention

All numbers expressing dimensions, physical characteristics, quantities of ingredients, reaction conditions, and the like used in the specification and claims are to be understood as being modified in all instances by the term "about". Accordingly, unless indicated to the contrary, the numerical values set forth in the following specification and claims may vary depending upon the desired properties sought to be obtained by the present invention. At the very least, and not as an attempt to limit the application of the doctrine of equivalents to the scope of the claims, each numerical parameter should at least be construed in light of the number of reported significant digits and by applying ordinary rounding techniques. Moreover, all ranges disclosed herein are to be understood to encompass any and all subranges subsumed therein. For example, a stated range of "1 to 10" should be considered to include any and all subranges between (and inclusive of) the minimum value of 1 and the maximum value of 10; that is, all subranges beginning with a minimum value of 1 or more and ending with a maximum value of 10 or less, e.g., 1 to 7.8, 3 to 4.5, 6.3 to 10.

As used herein, the terms "on", "applied on/over", "formed on/over", "deposited on/over", "overlay" and "provided on/over" mean formed, deposited, or provided on but not necessarily in contact with the surface. For example, a coating layer "formed over" a substrate does not preclude the presence of one or more other coating layers of the same or different composition located between the formed coating layer and the substrate. For instance, the substrate can include a conventional coating such as those known in the art for coating substrates, such as glass or ceramic.

As used herein, "nanostructures" refers to a three dimensional object wherein the length of the longest dimension ranges from 1 nm to 1,000 nm, for example, or 1 nm to 500 nm, or 1 nm to 100 nm, or 1 nm to 40 nm.

In a non-limiting embodiment, the present invention is a coated substrate comprising a substrate; an undercoating over the substrate; and a functional coating over the undercoating. Suitable substrates for the present invention include, but are not limited to, polymers, ceramics and glass. The substrate can be glass; especially window glass made by the float process. The glass can be of any type, such as conventional float glass or flat glass, and can be of any composition having any optical properties, e.g., any value of visible transmission, ultraviolet transmission, infrared transmission, and/or total solar energy transmission. Examples of suitable glass include borosilicate glass and soda-lime-silica glass compositions, which are well known in the art. Exemplary glass compositions are disclosed in, but are not limited to, U.S. Patent Nos. 5,071,796; 5,837,629; 5,688,727; 5,545,596; 5,780,372; 5,352,640; and 5,807,417.

Suitable ceramic substrates include oxides such as alumina, zirconia, and clay and non-oxides such as silicon carbide, alumina nitride, etc.

Suitable polymers include polymethylmethacrylate, polycarbonate, polyurethane, polyvinylbutyral (PVB) polyethyleneterephthalate (PET), or copolymers of any monomers for preparing these, or mixtures thereof.

The undercoating overlays at least a portion of the substrate and comprises a single layer of coating

The undercoating is a single layer comprised of a mixture of alumina and silica; or alumina, titania and silica. Mixtures of the described materials can be made according to methods that are well known in the art. Suitable mixtures comprise every combination of ranges for the aforementioned materials including ternary and quaternary combinations. The exact composition of the mixture will depend on the required properties of the undercoating such as the deposition properties, film durability, aesthetic properties, crystallinity, etc.

The composition of the undercoating can be homogeneous throughout, vary randomly throughout the layer, or have a graded progression. For example, the undercoating can be made of a mixture of two materials, a first material and a second material, and have a composition that varies in a graded progression between interfaces such as, for example, a substrate and a functional coating. The composition of the undercoating adjacent to the substrate can be composed primarily of or exclusively of the first material and as the distance from the substrate increases, the concentration of the first material in the undercoating decreases and the concentration of the second material in the undercoating increases. At a certain distance from the substrate, the composition of the undercoating can be predominantly or exclusively comprised of the second material.

In one non-limiting embodiment of the invention, the change in the concentrations of the materials is linear.

The undercoating of the present invention can be applied using conventional application techniques such as chemical vapor deposition ("CVD"), spray pyrolysis, and magnetron sputtered vacuum deposition ("MSVD") as are well known in the art.

Suitable CVD methods of deposition are described in the following references: U.S. Patent Nos. 4,853,257; 4,971,843; 5,464,657; 5,599,387; and 5,948,131.

Suitable spray pyrolysis methods of deposition are described in the following references: U.S. Patent Nos. 4,719,126; 4,719,127; 4,111,150; and 3,660,061.

Suitable MSVD methods of deposition are described in the following references: U.S. Patent Nos. 4,379,040; 4,861,669; and 4,900,633.

The undercoating of the present invention can be any thickness. For example, the thickness of the undercoating can be at least 10 nm, or range from 10 nm to 1,000 nm, or from 10 nm to 500 nm, or from 10 nm for 100 nm. The exact thickness of undercoating is determined by the functional coating that overlays the undercoating as well as the end use of the coated substrate.

According to the present invention, a functional coating overlays at least a portion of the undercoating. The functional coating can be a single layer coating or a multiple layer coating. As used herein, the term "functional coating" refers to a coating that modifies one or more physical properties of the substrate over which it is deposited, e.g., optical, thermal, chemical or mechanical properties, and is not intended to be entirely removed from the substrate during subsequent processing. The functional coating can have one or more layers of coating having the same or different composition or functionality.

The functional coating comprises a layer of nanostructures (i.e., the nanostructures make up a coating), namely titania nanostructures. The nanostructures can have the following shapes: spherical, polyhedral-like cubic, triangular, pentagonal, diamond-shaped, needle-shaped, rod-shaped, disc-shaped, etc. The nanostructures can have an aspect ratio ranging from 1:1 to 1:1,000 or 1:1 to 1:100. The nanostructures can have a degree and orientation of crystallinity ranging from completely amorphous (0 percent crystallinity) to fully oriented along one crystal orientation. For example, the titania nanostructures can be in the anatase or rutile, or brookite phase. The nanostructures can be in contact with each other or separated by a distance of from 1 nm to 1000 nm. The longest dimension ranges of the titania nanostructures can range from 1 nm to 500 nm, for example from 30 nm to 50 nm.

The nanostructures are applied over the undercoating in the following manner. The first step in the present invention involves fluidizing a precursor for the nanostructures. The specific precursor utilized will depend on the desired nanostructure.

The following precursors for the titania nanostructures can be used: titanium tetra iso-propoxide, titanium tetra chloride, titanium tetra n-butoxide, titanium tetraethoxide, titanium tetra methoxide, titanyl acetylacetonate, titanium tetrapropoxide and titanium tetra (triethanolaminato). Another suitable precursor is a solution containing titanium ions. For example, a solution comprising 0.1-50.0 weight percent of titanium tetra-iso-propoxide dissolved in a mixture of ethanol. 2,4-pentanedione can be added as a stabilizer.

Prior to fluidization, the temperature of the starting material can be maintained at a temperature that allows sufficient sublimation or vaporization from a solid or a liquid starting material or at a temperature at which the starting material has a sufficiently low viscosity for atomization. In a non-limiting embodiment, the temperature of the starting material can be greater than or equal to room temperature.

The precursor for the nanostructures can be fluidized in any manner known in the art, wherein the fluidizing comprises atomizing the starting material into an aerosol; evaporating the starting material into a gas phase; subliming the starting material into a gas phase, or other similar techniques. For example, in a non-limiting embodiment, the precursor can be fluidized using a commercially available atomizer such as Model 9306 from TSI, Inc. (Shoreview, MN) to make an aerosol.

The second step involves forcing the fluidized material toward the surface of the article. The fluidized material can be forced by imparting momentum to the fluidized materials using a moving gas stream. For example, compressed air, compressed nitrogen, etc. can be used to direct the fluidized material toward the surface of the article. Also, a gravitational field, a thermophoretic field, an electrostatic field, a magnetic field or similar can also be used to force the fluidized material toward the surface of the article.

In many instances, the nanostructures will form when the fluidized material impacts the surface of the undercoating. Such is especially likely to occur if the temperature of the surface of the undercoating ranges from 25ºF to 3000ºF (-4ºC to 1649ºC).

The third step involves passing the fluidized material through a high energy zone, i.e. a zone that will facilitate the formation of nanostructures. The manner in which the high energy facilitates the formation depends on the type of high energy zone used as discussed below. The passing step can be accomplished in any conventional manner such as by supplying an additional force or pressure to the fluidized material. The passing of the fluidized material step can occur (a) before the forcing step; (b) after the forcing step but before the fluidizing material comes in contact with the surface of the substrate; (c) during the forcing step; or (d) after the forcing step and after the fluidized material comes in contact with the surface of the substrate. In the high energy zone, the fluidized material can be excited using heat, electromagnetic radiation, high voltage or similar means to cause the fluidized material to lose volatiles, condense, chemically react, decompose, change phase or a combination thereof.

Suitable high energy zones include, are limited to, hot wall reactors, chemical vapor particle deposition reactors ("CVPD"), combustion deposition reactors, plasma chambers, laser beams and microwave chambers.

In a non-limiting embodiment, a hot wall reactor is the high energy zone. The hot wall reactor is essentially a heated chamber. Starting material can be delivered to the hot wall reactor by a spray system such as a forced aerosol generator. Inside the reactor, the fluidized material can lose volatiles, condense, chemically react, decompose, change phase or a combination thereof.

Without limiting the invention, the following describes some of the typical parameters for the operation of the hot wall reactor in the present invention. Typically, the temperature inside the hot wall reactor ranges from 300ºF to 2,100ºF (149ºC to 1,149ºC), for example, 900ºF to 1,650ºF (482ºC to 899ºC) or 1,100ºF to 1,400ºF (593ºC to 760ºC). The pressure inside the reactor can be ambient or can be independently controlled. The atmosphere inside the reactor can be nitrogen, air, or a mixture of 2 to 5 percent by volume hydrogen and 98 to 95 percent by volume nitrogen. The residence time (time the material is in the reactor) in the reactor has to be sufficient to enable the requisite processing in the high energy zone to occur.

In another non-limiting embodiment, a CVPD reactor is the high energy zone. The CVPD is essentially a heated chamber. In a CVPD process, starting material can be evaporated to a gas phase as in a conventional chemical vapor deposition system. The gas phase is then forced through the CVPD reactor, for example, as a result of a pressure gradient. Inside the reactor, the fluidized material loses volatiles, condenses, chemically reacts, decomposes, changes phases or a combination thereof.

Without limiting the invention, the following describes some typical parameters for CVPD reactor operation in the present invention. Typically, the temperature inside the CVPD can range from 300ºF to 2,100ºF (149ºC to 1,149ºC), for example, 900ºF to 1,650ºF (482ºC to 899ºC) or 1,100ºF to 1,400ºF (593ºC to 760ºC). The pressure inside the reactor can be ambient or can be independently controlled. The atmosphere inside the reactor can be nitrogen, air, or a mixture of 2 to 5 percent by volume hydrogen and 98 to 95 percent by volume nitrogen. The residence time in the reactor has to be sufficient to enable the requisite processing in the high energy zone to occur.

In yet another non-limiting embodiment, a combustion deposition reactor is the high energy zone. In a combustion deposition reactor, starting material can be atomized, for example, by an aerosol generator to form an aerosol steam. The aerosol can be introduced into a flame in the reactor at any location within the flame. At different locations along the flame, the temperature of the flame is different, the chemical make-up of the flame is different, etc.

In the alternative, the aerosol can be mixed in with the gaseous mixture, e.g. air or oxygen or gas, responsible for the flame. The mixture that makes the flame can be a mixture of a combustible material and an oxidizing material such as air and natural gas, oxygen and natural gas, or carbon monoxide and oxygen.

The temperature range of the flame typically can range from 212ºF to 2,900ºF (100ºC to 1,593ºC), for example, or 400ºF to 2,300ºF (204ºC to 1,260ºC). The residence time (time the material is in the flame) has to be sufficient to enable the requisite processing in the high energy zone to occur.

In another non-limiting embodiment, a plasma chamber is the high energy zone. In the plasma chamber, the fluidized material is forced through a gas discharge, for example an atmospheric or low pressure plasma, and is energized through collision with electrons or ions that constitute the plasma. The plasma can comprise a reactive gas like oxygen, an inert gas like argon or a mixture of gases. For example, the plasma chamber can be a stainless steel chamber in which a gaseous phase is excited to form a plasma.

The pressure in the plasma chamber can range from 10 mtorr to 760 torr. The residence time in the plasma chamber has to be sufficient to enable the requisite processing in the high energy zone to occur.

In a further non-limiting embodiment, a laser beam is the high energy zone. The fluidized material can pass through the laser beam and absorb photons. A suitable lasers includes, but is not limited to, a CO₂ laser with a wavelength of 10,600 nm. See U.S. Patent No. 6,482,374, which is hereby incorporated by reference, for an example of a suitable laser.

In various non-limiting embodiments of the invention, additional coating layers can be over the layer of nanostructures. For example, a conventional titania coating can be over a layer of titania nanostructures.

The process of the present invention can comprise optional steps such as steps related to heating and/or cooling the substrate. For example, the substrate can be heated to bend or temper the final article. Heating processes for bending or tempering can serve as a high energy zone as described above. Also, the substrate can be controllably cooled to produce annealed glass as is well known in the art.

In a non-limiting embodiment, the present invention is part of an on-line production system. For example, the process of the present invention can be part of a float glass operation where the process is performed at or near the hot end of a conventional float bath. The invention is not limited to use with the float process. For example, the invention can in a vertical draw process.

The coated substrate of the present invention demonstrates improved performance properties such as durability, photocatalytic activity, and aesthetic properties. Some of the improved performance stems from the undercoating serving as a barrier layer to prevent mobile ions in the substrate from migrating to the surface and negatively interacting with the functional coating. In a non-limiting embodiment of the invention, an undercoating that is a barrier layer to sodium ions overlays at least a portion of a glass substrate (sodium ions are mobile in glass) and a functional coating comprising a photocatalytic coating such as a titania coating overlays at least a portion of the undercoating. Such a coated substrate can exhibit increased durability and increased photocatalytic activity because the alkali ions are prevented from migrating to the surface.

### EXAMPLES

The present invention will now be illustrated by the following, non-limiting examples. Samples 1-4 were prepared in the following manner: A precursor for titania nanostructures comprising titanium tetra-iso-propoxide dissolved in ethanol in addition with a stabilizer 2,4-pentanedione to produce a solution that was 8 wt% titanium tetra iso-propoxide in solution.

The precursor solution was atomized using a standard aerosol generator. The aerosol was then forced using compressed air directly onto a 3.0 mm thick clear float glass substrate without an undercoating. The temperature of the glass was 1,200ºF (649ºC). The estimated average dimension of the nanostructures formed was 50 nm. The longest dimensions of the nanostructures formed ranged from 5 nm to 100 nm. The estimated density of the nanostructures formed was 2.96 g/cm³.

Samples 5-8 were prepared in the same manner as above except the clear glass substrate was coated with a 54.1 nm thick undercoating prior to undergoing the process in which the layer of titania nanostructures was applied. The undercoating comprised a mixture of 85% silica and 15% alumina based on volume and was applied over the substrate using standard magnetron sputtering vacuum deposition (MSVD) techniques.

Table 1 shows the durability performance of coated substrates according to the present invention. The test was conducted in the following manner: The samples were placed in a Cleveland Condensation Chamber (the chamber was at 140 ºF at 100% humidity) and the change in reflected color ΔE (MacAdam Units (FMC II dE)) was measured and recorded every week for a period of 10 weeks. If the ΔE was larger than 4 MacAdam Units, the sample was deemed to fail the durability test. A substrate had to exhibit a ΔE of less than 4 MacAdam Units for ten weeks to pass the durability test. The MacAdam Unit (FMC II dE) is a universally adopted color matching system.

**Table 1. Results of the Durability Test**

| | Sample 1 (Comparative Example) | Sample 2 (Comparative Example) | Sample 3 (Comparative Example) | Sample 4 (Comparative Example) | Sample 5 | Sample 6 | Sample 7 | Sample 8 |
|---|---|---|---|---|---|---|---|---|
| Week 1 | 28.61 | 3.07 | 1.94 | 4.44 | 0.72 | 0.78 | 1.61 | 0.87 |
| Week 2 | Failed | 22.62 | 19.31 | 31.71 | 0.61 | 0.68 | 1.48 | 0.67 |
| Week 3 | | Failed | Failed | Failed | 2.35 | 2.84 | 0.7 | 1.89 |
| Week 4 | | | | | 1.53 | 1.04 | 0.49 | 0.68 |
| Week 5 | | | | | 0.64 | 0.76 | 1.58 | 0.56 |
| Week 6 | | | | | 0.56 | 1.14 | 1.1 | 0.28 |
| Week 7 | | | | | 0.75 | 0.46 | 2.09 | 1.38 |
| Week 8 | | | | | 0.76 | 0.38 | 1.59 | 1.28 |
| Week 9 | | | | | 0.65 | 0.14 | 2.13 | 1.28 |
| Week 10 | | | | | 0.41 | 0.18 | 1.63 | 0.99 |

Table 2 shows the photocatalytic activity of coated substrates according to the present invention. Pairs of samples (one with an undercoating and one without) were prepared in the manner described above, with each of the pairs having a layer of titania nanostructures with different titania amounts per square centimeter as measured by HRF.

The photocatalytic activity (PCA) was determined using the stearic acid test described below. The coated substrates of the examples were coated with a stearic acid test film to measure its photocatalytic activity. A stearic acid/methanol solution having a concentration of about 6x10⁻³ moles of stearic acid per liter of solution was applied by pipetting the stearic acid solution at a rate of about 2 ml/10 seconds over the center of the substrate, while the substrate was spinning at a rate of about 1000 revolutions per minutes. The stearic acid flowed across the surface of the substrate by centrifugal force to provide a stearic acid film of generally uniform thickness on the surface of the substrate of about 200 Å in thickness. The thickness of the stearic acid layer was not constant along the length of the substrate but was thickest at the ends of the substrate and thinnest at the center of the substrate due to the applied centrifugal force.

After receiving a coating of stearic acid, the substrates were exposed to ultraviolet radiation from a black light source normal to coating side of the substrate providing an intensity of about 24 W/m² at the surface of the substrate for approximately 60 minutes to induce photocatalytically-activated self-cleaning of the stearic acid test film. Periodic FTIR spectrophotometer measurements were made over the cumulated 60 minute ultraviolet light exposure period using an FTIR spectrophotometer equipped with an MCT detector to quantitatively measure photocatalytic activity. More particularly, the coated substrates were exposed to ultraviolet radiation for a measured period of time, after which the substrates were placed in the FTIR spectrophotometer where the integrated area under the C--H absorption band of stearic acid was measured to determine photocatalytic activity. The substrates were again exposed to ultraviolet radiation for an additional measured period of time to remove additional stearic acid, after which another FTIR measurement was made. This process was repeated, and a plot of the integrated IR absorption intensity of the C--H stretching vibrations versus cumulated time of exposure to ultraviolet light was obtained, the slope of which provided the photocatalytic activity for the coated substrates. The greater the slope, the greater the photocatalytic activity of the coating.

**Table 2. Results for Photocatalytic Activity**

| | Without an undercoating (Comparative Example) | With an undercoating |
|---|---|---|
| Amount of the Titania nanostructures ( g·cm⁻²) | PCA (× 10⁻³ min⁻¹·cm⁻¹) | PCA (× 10⁻³ min⁻¹·cm⁻¹) |
| 6.0 | 2.6 | 33 |
| 8.1 | 8.7 | 48 |
| 11.0 | 24 | 59 |
| 12.5 | 25.1 | 95.8 |

### Conclusion

The present invention provides coated substrates with improved durability and photocatalytic activity. As shown in Table 1, only the substrates according to the present invention having an undercoating were able to pass the durability test. All of the samples that did not contain an undercoating failed in less than three weeks.

As shown in Table 2, substrates according to the present invention exhibit improved photocatalytic activity. A coated substrate according to the present invention with an undercoating that is at least 54 nm thick and nanostructures having a density of at least 6 g·cm⁻² has a PCA of at least 33 × 10⁻³ min⁻¹·cm⁻¹. Depending on the amount of the titania nanostructures per square centimeter, coated substrates according to the present invention showed photocatalytic activity values ranging from 33 × 10⁻³ min⁻¹·cm⁻¹ to 96 × 10⁻³ min⁻¹·cm⁻¹. Coated substrates that were not produced in accordance with the present invention showed considerably lower photocatalytic activity. The photocatalytic activity of those substrates ranged from 2.6 × 10⁻³ min⁻¹·cm⁻¹ to 25 × 10⁻³ min⁻¹·cm⁻¹.

It will be readily appreciated by those skilled in the art that modifications may be made to the invention without departing from the concepts disclosed in the foregoing description. Such modifications are to be considered as included within the scope of the invention. Accordingly, the particular embodiments described in detail above are illustrative only and are not limiting as to the scope of the invention, which is to be given the full breadth of the appended claims.

## Claims

1. A method of making a coated substrate comprising:
a. depositing a single layer undercoating comprising a mixture of alumina and silica over at least a portion of the substrate;
b. fluidizing a precursor for titania nanostructures selected from titanium tetra iso-propoxide, titanium tetra chloride, titanium tetra n-butoxide, titanium tetraethoxide, titanium tetra methoxide, titanyl acetylacetonate, titanium tetrapropoxide and titanium tetra (triethanolaminato), wherein the fluidizing comprises atomizing the precursor into an aerosol;
c. passing the aerosol through a high energy zone selected from a hot wall reactor, a chemical vapor particle deposition reactor, a combustion deposition reactor, a plasma chamber, laser beam and a microwave chamber; and
d. forcing the fluidized precursor toward the substrate using compressed gas, to coat the undercoating with a layer of nanostructures.

2. The method according to claim 1, wherein the deposited undercoating has a thickness of at least 10 nm.

3. The method according to claim 1, wherein the nanostructures have an aspect ratio ranging from 1:1 to 1:1,000.

4. The method according to claim 1, wherein the substrate is glass.

5. A glass substrate coated with a layer of nanostructures formed by a process comprising:
a. depositing a single layer undercoating comprising a mixture of alumina and silica over at least a portion of the substrate;
b. fluidizing a precursor for titania nanostructures selected from titanium tetra iso-propoxide, titanium tetra chloride, titanium tetra n-butoxide, titanium tetraethoxide, titanium tetra methoxide, titanyl acetylacetonate, titanium tetrapropoxide and titanium tetra (triethanolaminato), wherein the fluidizing comprises atomizing the precursor into an aerosol;
c. passing the aerosol through a high energy zone selected from a hot wall reactor, a chemical vapor particle deposition reactor, a combustion deposition reactor, a plasma chamber, laser beam and a microwave chamber; and
d. forcing the fluidized precursor toward the substrate to coat the undercoating with a layer of nanostructures.

## Patentansprüche

1. Ein Verfahren zum Herstellen eines beschichteten Substrats umfassend:
a. Aufbringen einer einlagigen Grundierungsbeschichtung umfassend eine Mischung aus Aluminiumoxid und Siliziumoxid über wenigstens einem Teil des Substrats;
b. Fluidisieren eines Vorläufers für Titanoxidnanostrukturen ausgewählt aus Titantetraisopropoxid, Titantetrachlorid, Titantetra-n-butoxid, Titantetraethoxid, Titantetramethoxid, Titanylacetylacetonat, Titantetrapropoxid und Tetrakis(triethanolamino)titan, wobei das Fluidisieren ein Atomisieren des Vorläufers zu einem Aerosol umfasst;
c. Hindurchleiten des Aerosols durch eine hochenergetische Zone ausgewählt aus einem Heißwandreaktor, einem chemischen Dampfphasenpartikelabscheidungsreaktor, einem Verbrennungsabscheidungsreaktor, einer Plasmakammer, einem Laserstrahl und einer Mikrowellenkammer; und
d. Lenken des fluidisierten Vorläufers auf das Substrat unter Verwendung von komprimiertem Gas, um die Grundierungsbeschichtung mit einer Schicht von Nanostrukturen zu beschichten.

2. Das Verfahren gemäß Anspruch 1, wobei die aufgebrachte Grundierungsbeschichtung eine Schichtdicke von mindestens 10 nm aufweist.

3. Das Verfahren gemäß Anspruch 1, wobei die Nanostrukturen ein Aspektverhältnis, das von 1:1 bis 1:1.000 reicht, aufweisen.

4. Das Verfahren gemäß Anspruch 1, wobei das Substrat Glas ist.

5. Ein Glassubstrat, beschichtet mit einer Schicht von Nanostrukturen, gebildet durch ein Verfahren umfassend:
a. Aufbringen einer einlagigen Grundierungsbeschichtung umfassend eine Mischung aus Aluminiumoxid und Siliziumoxid über wenigstens einem Teil des Substrats;
b. Fluidisieren eines Vorläufers für Titanoxidnanostrukturen ausgewählt aus Titantetraisopropoxid, Titantetrachlorid, Titantetra-n-butoxid, Titantetraethoxid, Titantetramethoxid, Titanylacetylacetonat, Titantetrapropoxid und Tetrakis(triethanolamin)titan, wobei das Fluidisieren ein Atomisieren des Vorläufers zu einem Aerosol umfasst;
c. Hindurchleiten des Aerosols durch eine hochenergetische Zone ausgewählt aus einem Heißwandreaktor, einem chemischen Dampfphasenpartikelabscheidungsreaktor, einem Verbrennungsabscheidungsreaktor, einer Plasmakammer, einem Laserstrahl und einer Mikrowellenkammer; und
d. Lenken des fluidisierten Vorläufers auf das Substrat unter Verwendung von komprimiertem Gas, um die Grundierungsbeschichtung mit einer Schicht von Nanostrukturen zu beschichten.

## Revendications

1. Procédé de fabrication d'un substrat revêtu, comportant les étapes suivantes :
a) déposer sur au moins une partie du substrat une seule couche de sous-revêtement comprenant un mélange d'alumine et de silice ;
b) fluidiser un précurseur de nanostructures en oxyde de titane, choisi parmi du tétra(isopropoxy)titane, du tétrachlorure de titane, du tétra(n-butoxy)titane, du tétra(éthoxy)titane, du tétra(méthoxy)-titane, de l'acétyl-acétonate de titanyle, du tétra(propoxy)titane et du tétra(triéthanolaminato)titane, étant entendu que cette opération de fluidisation comporte le fait de faire du précurseur, par atomisation, un aérosol ;
c) faire passer cet aérosol dans une zone de haute énergie, choisie parmi un réacteur à paroi chaude, un réacteur de dépôt chimique de particules à partir d'une phase vapeur, un réacteur de dépôt par combustion, une enceinte à plasma, un faisceau laser et une enceinte à micro-ondes ;
d) et diriger de force vers le substrat le précurseur fluidisé, au moyen d'un gaz comprimé, pour revêtir le sous-revêtement d'une couche de nanostructures.

2. Procédé conforme à la revendication 1, dans lequel le sous-revêtement déposé est épais d'au moins 10 nm.

3. Procédé conforme à la revendication 1, dans lequel les nanostructures présentent un rapport de forme qui vaut de 1/1 à 1/1000.

4. Procédé conforme à la revendication 1, dans lequel le substrat est en verre.

5. Substrat de verre, revêtu d'une couche de nanostructures qui a été formée par un procédé comportant les étapes suivantes :
a) déposer sur au moins une partie du substrat une seule couche de sous-revêtement comprenant un mélange d'alumine et de silice ;
b) fluidiser un précurseur de nanostructures en oxyde de titane, choisi parmi du tétra(isopropoxy)titane, du tétrachlorure de titane, du tétra(n-butoxy)titane, du tétra(éthoxy)titane, du tétra(méthoxy)titane, de l'acétyl-acétonate de titanyle, du tétra(propoxy)titane et du tétra(triéthanolaminato)titane, étant entendu que cette opération de fluidisation comporte le fait de faire du précurseur, par atomisation, un aérosol ;
c) faire passer cet aérosol dans une zone de haute énergie, choisie parmi un réacteur à paroi chaude, un réacteur de dépôt chimique de particules à partir d'une phase vapeur, un réacteur de dépôt par combustion, une enceinte à plasma, un faisceau laser et une enceinte à micro-ondes ;
d) et diriger de force vers le substrat le précurseur fluidisé, pour revêtir le sous-revêtement d'une couche de nanostructures.
